# EUROPEAN PATENT SPECIFICATION

(11) **EP 2 975 460 B1**
(45) Date of publication and mention of the grant of the patent: **05.04.2017**
(21) Application number: 14807161.6
(22) Date of filing: 21.05.2014
(51) Int. Cl.: G03F 7/30, G03F 7/00

(54) **METHOD FOR TREATING PRINTING PLATE DEVELOPER LIQUID AND TREATMENT SYSTEM FOR PRINTING PLATE DEVELOPER LIQUID**
VERFAHREN ZUR BEHANDLUNG EINER DRUCKPLATTEN-ENTWICKLERFLÜSSIGKEIT UND SYSTEM ZUR BEHANDLUNG EINER DRUCKPLATTEN-ENTWICKLERFLÜSSIGKEIT
PROCÉDÉ DE TRAITEMENT D'UN LIQUIDE RÉVÉLATEUR DE PLAQUE D'IMPRESSION ET SYSTÈME DE TRAITEMENT D'UN LIQUIDE RÉVÉLATEUR DE PLAQUE D'IMPRESSION

(30) Priority: 03.06.2013 JP 2013116791
(43) Date of publication of application: 20.01.2016
(73) Proprietor: Sumitomo Riko Company Limited, Komaki-shi, Aichi 485-8550 (JP)
(72) Inventor: MATSUOKA, Koki, Komaki-shi, Aichi 485-8550 (JP)
(74) Representative: Müller-Boré & Partner Patentanwälte PartG mbB
(86) International application number: PCT/JP2014/063443
(87) International publication number: WO 2014/196358

(56) References cited:
- JP-A- S5 830 753
- JP-A- H07 281 451
- JP-A- H09 258 458
- JP-A- 2001 212 596
- JP-A- 2005 103 805
- JP-A- 2005 103 805
- JP-A- 2009 208 000
- JP-A- 2009 208 000
- JP-A- 2011 215 355
- JP-A- 2011 215 355
- JP-A- 2013 154 266

## Description

### Technical Field

The present invention relates to a method for treating a printing plate developer liquid, in which a developer waste liquid is treated, the developer waste liquid containing polymer components that are generated in a developing step to perform development with the use of an aqueous developer.

### Background Art

Conventionally, anastatic printing, intaglio printing, or planographic printing is done on printing subjects such as wrapping materials, labels, and magazines with the use of printing plates. An original printing plate includes a photosensitive layer made of a photosensitive resin composition that is formed on a board such as a PET resin. A printing plate is made by irradiating the photosensitive layer with ultraviolet rays through a negative film that is brought into intimate contact with the photosensitive layer to form a relief image by removing uncured portions.

A variety of methods are known as a printing plate developing method. For example, in a developing method in which development is performed with the use of an aqueous developer liquid mainly made of water, development is performed by immersing a printing plate in the aqueous developer liquid to rub out uncured portions into the aqueous developer liquid with the use of a brush. Because the developer waste liquid contains polymer components that are rubbed out, if the developer waste liquid is reused as a developer liquid without being treated, a new printing plate gets dirty, so that the developer waste liquid is sometimes discarded. However, this method produces a large amount of waste, so that improvement is required from an environmental standpoint.

For example, PTL 1 proposes a method in which coagula in the developer waste liquid are removed therefrom with the use of a filter to reuse the filtrate as a developer liquid. In addition, PTL 2 proposes a method in which polymer components that are coagulated by the addition of an aggregating agent to the developer waste liquid are removed from the developer waste liquid.

Furthermore JP 2009-208000 A discloses a development method for developing planographic printing plates having a silicone layer with an automatic image development apparatus that includes an adsorption treatment of wastewater emitted from an image development part and a water washing part of the development apparatus by an activated carbon treatment tank.

JP 2005-103805 A discloses an image development method for producing a lithographic printing plate using an image recording layer coating liquid containing an infrared absorber, polymerization initiator and polymerizable compound on a support. The dampening water and printing ink used during printing, are adsorbed by activated carbon which is used as an adsorption filter.

JP 2011-215355 A relates to a method and an apparatus for regeneration of resist removing liquid generated during manufacture of e.g. semiconductor device, and involves flowing resist removing liquid component-containing water to an adsorbent, thermally treating the adsorbent containing activated carbon with water vapor, extracting and concentrating the components of a resist peeling liquid.

### Citation List

### Patent Literature

PTL 1: Patent JP H07-333861
PTL 2: Patent JP 2001-47060

### Summary of Invention

### Problem that the Invention is to Solve

However, in the developing method in which development is performed with the use of an aqueous developer liquid, all of the polymer components contained in the developer waste liquid are not coagulated, and some exist dissolved in the developer waste liquid. In addition, some additives other than the polymer components could be also contained in the uncured portions in the photosensitive layer, and some of the additives also exist dissolved in the developer waste liquid. Thus, only by removing coagula in the developer waste liquid with the use of a filter, it is impossible to remove also these dissolved materials from the developer waste liquid, so that it is difficult to reuse the developer waste liquid.

In addition, using the aggregating agent could cause the aggregating agent to remain in the developer waste liquid, so that if the developer waste liquid is reused as the developer liquid, the polymer components rubbed out during the development could be coagulated to adhere to the printing plate or the brush. In addition, the water-soluble polymer that is dissolved into the developer waste liquid is difficult to coagulate with the use of an aggregating agent.

The present invention is made in view of the problems described above, and an object of the present invention is to provide a method for treating a printing plate developer liquid by which a developer waste liquid can be reused by also removing components that are dissolved in the developer waste liquid, and a system for treating a printing plate developer liquid.

### Means for solving the Problem

In order to solve the problems described above, a method for treating a printing plate developer liquid according the present invention includes the steps of performing a waste liquid treatment by making a developer waste liquid pass through a packed bed filled with activated carbon, the developer waste liquid containing a polymer component that is generated in a developing step to perform development of a printing plate member including a photosensitive resin layer on which a latent image is formed with the use of an aqueous developer liquid mainly made of water, the polymer content comprising a water-insoluble polymer selected from butadiene rubber, chloroprene rubber, acrylonitrile butadiene rubber, acrylic rubber, epichlorohydrin rubber, urethane rubber, isoprene rubber, styrene-isoprene rubber, styrene-butadiene rubber, ethylene-propylene copolymer, and chlorinated polyethylene; and replacing a passage liquid that is made to pass through the packed bed in a supply unit supplying the aqueous developer liquid in a developing machine, and reusing the passage liquid as an aqueous developer liquid.

The method according to the present invention includes that a switch is made alternately between a washing treatment to wash the activated carbon in the packed bed by making water vapor pass through the packed bed through which the developer waste liquid is made to pass and a waste liquid treatment to make the developer waste liquid pass through the packed bed filled with the activated carbon.

It is preferable that the packed bed should include a plurality of packed beds, and while the waste liquid treatment is performed on one packed bed to another, the washing treatment is performed on one of the packed beds in which the waste liquid treatment is stopped when the waste liquid treatment is performed on another packed bed.

In another aspect, a system for treating a printing plate developer liquid includes a waste liquid recovery unit arranged to recover a developer waste liquid containing a polymer component that is generated in a developing step to perform development of a printing plate member including a photosensitive resin layer on which a latent image is formed with the use of an aqueous developer liquid mainly made of water, a packed bed filled with activated carbon that is connected to the waste liquid recovery unit, and through which the developer waste liquid is made to pass, and a passage liquid replacing unit that is connected to the packed bed and arranged to replace a passage liquid that is made to pass through the packed bed in a supply unit supplying the aqueous developer liquid in a developing machine.

It is preferable that the system should further include a washing unit connected to the packed bed and arranged to wash the activated carbon in the packed bed by making water vapor pass through the packed bed through which the developer waste liquid is made to pass, and a switch should be made alternately between a waste liquid treatment to make the developer waste liquid pass through the packed bed and a washing treatment to wash the activated carbon in the packed bed through which the developer waste liquid is made to pass.

It is preferable that the packed bed should include a plurality of packed beds, and the packed beds should be connected to the common waste liquid recovery unit and be switchable from one to another to perform the waste liquid treatment thereon, and that the packed beds should be connected to the common washing unit and be switchable from one to another to perform the washing treatment thereon, and that while the waste liquid treatment is performed on one packed bed to another, the washing treatment should be performed on one of the packed beds in which the waste liquid treatment is stopped when the waste liquid treatment is performed on another packed bed.

### Advantageous Effects of Invention

According to the method for treating a printing plate developer liquid according to the present invention, because the developer waste liquid is made to pass through the packed bed filled with the activated carbon, the developer waste liquid containing the polymer component that is generated in the developing step to perform development with the use of the aqueous developer liquid mainly made of water, it is possible to remove not only a coagulum in the developer waste liquid but also remove the polymer components and additives dissolved in the developer waste liquid from the developer waste liquid by adsorption. Thus, the passage liquid can be replaced to the supply unit supplying the aqueous developer liquid in the developing machine and reused as an aqueous developer liquid, whereby the treatment system in which the developer waste liquid is not discarded can be achieved.

At this time, by making a switch alternately between the washing treatment to wash the activated carbon in the packed bed by making water vapor pass through the packed bed through which the developer waste liquid is made to pass and the waste liquid treatment to make the developer waste liquid pass through the packed bed filled with the activated carbon, the activated carbon in the packed bed can be recycled, and the packed bed can be used again in the waste liquid treatment without changing the activated carbon.

By using the plurality of packed beds to perform the waste liquid treatment on one packed bed to another, and performing the washing treatment on one of the packed beds in which the waste liquid treatment is stopped when the waste liquid treatment is performed on another packed bed, the waste liquid treatment can be performed in succession.

In addition, according to a system for treating a printing plate developer liquid, , because the developer waste liquid containing the polymer component is made to pass through a packed bed from the waste liquid recovery unit to remove a coagulum and a dissolved component in the developer waste liquid from the developer waste liquid, the passage liquid can be replaced to the supply unit supplying the aqueous developer liquid in the developing machine from the waste liquid recovery unit and reused as the aqueous developer liquid, whereby the treatment system in which the developer waste liquid is not discarded can be achieved.

At this time, by further including a washing unit connected to the packed bed and arranged to wash the activated carbon in the packed bed by making water vapor pass through the packed bed through which the developer waste liquid is made to pass, and making a switch alternately between a waste liquid treatment to make the developer waste liquid pass through the packed bed and a washing treatment to wash the activated carbon in the packed bed through which the developer waste liquid is made to pass, the activated carbon in the packed bed can be recycled, and the packed bed can be used again in the waste liquid treatment without changing the activated carbon.

By including a plurality of packed beds, connecting the packed beds to the common waste liquid recovery unit and making the packed beds switchable from one to another to perform the waste liquid treatment thereon, connecting the packed beds to the common washing unit and making the packed beds switchable from one to another to perform the washing treatment thereon, and by performing the waste liquid treatment on one packed bed to another, and performing the washing treatment on one of the packed beds in which the waste liquid treatment is stopped when the waste liquid treatment is performed on another packed bed, the waste liquid treatment can be performed in succession.

### Brief Description of Drawings

Fig. 1 is a view showing one example of a system for treating a printing plate developer liquid according to the present invention.
Fig. 2 is a view showing one example of a system for treating a printing plate developer liquid according to the present invention.

### Mode for Carrying Out the Invention

Next, a description of embodiments of the present invention will be provided.

The printing plate member used in the present invention defines a printing plate member on which development is performed with the use of an aqueous developer liquid mainly made of water. The printing plate member includes a photosensitive layer. The photosensitive layer is formed on, for example, a board. Examples of the board include a plastic film (plastic sheet) such as a PET film, a metal sheet made of stainless steel or aluminum, and a rubber sheet such as butadiene rubber.

The photosensitive layer is made of a layered photosensitive resin composition. The photosensitive resin composition contains polymer components such as a resin, rubber, and a latex, a photopolymerizable monomer, and a photopolymerization initiator, and further contains additives and the like as necessary. The polymer components may be water-soluble (or hydrophilic) or may be water-insoluble (or hydrophobic).

Examples of the resin of the polymer components include polyamide, polyvinyl alcohol, polyester, and polyurethane. Examples of the rubber of the polymer components include butadiene rubber, chloroprene rubber, and acrylonitrile-butadiene rubber.

When development is performed with the use of an aqueous developer liquid, the components of the photosensitive resin composition that are washed out with the developer liquid include a water-soluble (or hydrophilic) component and a water-insoluble (or hydrophobic) component. Examples of a water-soluble polymer (or a hydrophilic polymer) included in the water-soluble component include a water-soluble or water-swellable polyamide prepared by introducing a hydrophilic component into a polyamide (polyamide that is completely dissolved or completely dispersed into water by being soaked in water at 25°C for 24 hours), and a partially saponified polyvinyl acetate and derivatives thereof. Examples of a water-insoluble polymer (or a hydrophobic polymer) included in the water-insoluble component include various kinds of millable rubber. Specific examples thereof include butadiene rubber, chloroprene rubber, acrylonitrile butadiene rubber, acrylic rubber, epichlorohydrin rubber, urethane rubber, isoprene rubber, styrene-isoprene rubber, styrene-butadiene rubber, ethylene - propylene copolymer, and chlorinated polyethylene.

In the photosensitive resin composition containing the water-insoluble polymer, at least a part of the polymer components is not dissolved but dispersed, so that the viscosity of the washing liquid is low and thus there is an advantage that a waste liquid treatment is easily performed.

Examples of the photosensitive resin composition of a flexographic printing plate member among the printing plate members include photosensitive resin compositions containing a water-dispersible latex, millable rubber, a photopolymerizable monomer, or a photopolymerization initiator.

The water-dispersible latex defines polymer particles dispersed in water as a dispersed material. By removing water from the water-dispersible latex, polymers can be obtained. The water-dispersible latex is capable of providing the photosensitive resin composition with water developability.

Specific examples of the water-dispersible latex include water-dispersible latex polymers such as a polybutadiene latex, a natural rubber latex, a styrene-butadiene copolymer latex, an acrylonitrile-butadiene copolymer latex, a polychloroprene latex, a polyisoprene latex, a polyurethane latex, a methyl methacrylate-butadiene copolymer latex, a vinylpyridine polymer latex, a butyl polymer latex, a Thiokol polymer latex, and an acrylate polymer latex, and polymers obtained by copolymerizing these polymers with other components such as an acrylic acid and a methacrylic acid. A single kind of water-dispersible latex may be used alone, or two or more kinds of water-dispersible latexes may be used in combination.

Among these water-dispersible latexes, the water-dispersible latex having a butadiene skeleton or an isoprene skeleton in its molecular chain is preferred from the viewpoint of hardness. To be specific, a polybutadiene latex, a styrene-butadiene copolymer latex, an acrylonitrile-butadiene copolymer latex, a methyl methacrylate-butadiene copolymer latex, an acrylic acid-methyl methacrylate-butadiene copolymer latex, and a polyisoprene latex are preferred.

Millable rubber can increase the rubber elasticity of the photosensitive resin composition. By containing the millable rubber, the photosensitive resin composition can be expected to have an effect of, for example, easy printing on a printing subject. Specific examples of the millable rubber include butadiene rubber (BR), nitrile rubber (NBR), acrylic rubber, epichlorohydrin rubber, urethane rubber, isoprene rubber, styrene-isoprene rubber, styrene-butadiene rubber, an ethylene-propylene copolymer, and chlorinated polyethylene. A single kind of the millable rubber may be used alone, or two or more kinds of millable rubber may be used in combination.

Among the millable rubber, the butadiene rubber (BR) and the nitrile rubber (NBR) are preferred from the viewpoint of improving water developability, drying performance, and image reproducibility of the photosensitive resin composition. Further, the butadiene rubber (BR) is preferred from the viewpoint of having its rubber component especially dispersed finely in the photosensitive resin composition, and thus having excellent fine shape reproducibility allowing further improved image reproducibility.

The photopolymerizable monomer is capable of curing or cross-linking a photosensitive resin composition. Examples of the photopolymerizable monomer include an ethylenic unsaturated compound. Examples of the ethylenic unsaturated compound include a (meth)acrylic monomer, a (meth)acrylic oligomer, and a (meth)acrylic-modified polymer. Examples of the (meth)acrylic-modified polymer include (meth) acrylic-modified butadiene rubber and (meth) acrylic-modified nitrile rubber.

The ethylenic unsaturated compound may define a compound having only one ethylenic unsaturated bond, or may define a compound having two or more ethylenic unsaturated bonds.

Specific examples of the ethylenic unsaturated compound having only one ethylenic unsaturated bond include (meth)acrylates having a hydroxyl group such as a 2-hydroxyethyl (meth)acrylate, a 2-hydroxypropyl (meth)acrylate, a 2-hydroxybutyl (meth)acrylate, a 3-chloro-2-hydroxypropyl (meth)acrylate, and a β-hydroxy-β'-(meth)acryloyl oxyethyl phthalate, alkyl (meth) acrylates such as a methyl (meth) acrylate, an ethyl (meth)acrylate, a propyl (meth)acrylate, a butyl (meth)acrylate, an isoamyl (meth)acrylate, a 2-ethylhexyl (meth)acrylate, a lauryl (meth)acrylate, and a stearyl (meth) acrylate, cycloalkyl (meth) acrylates such as a cyclohexyl (meth)acrylate, alkyl halide (meth) acrylates such as a chloroethyl (meth) acrylate and a chloropropyl (meth)acrylate, alkoxyalkyl (meth) acrylates such as a methoxyethyl (meth)acrylate, an ethoxyethyl (meth)acrylate, and a butoxyethyl (meth)acrylate, phenoxyalkyl (meth)acrylates such as a phenoxyethyl acrylate and a nonyl phenoxyethyl (meth)acrylate, alkoxy alkylene glycol (meth)acrylates such as an ethoxy diethylene glycol (meth)acrylate, a methoxy triethylene glycol (meth)acrylate, and a methoxy dipropylene glycol (meth)acrylate, a 2,2-dimethylaminoethyl (meth)acrylate, a 2,2-diethylaminoethyl (meth)acrylate, a 2-hydroxyethyl (meth)acrylate, and a 3-chloro-2-hydroxypropyl (meth)acrylate.

Specific examples of the ethylenic unsaturated compound having two or more ethylenic unsaturated bonds include alkyldiol di (meth) acrylates such as a 1, 9- nonane diol di(meth)acrylate, polyethylene glycol di(meth) acrylates such as a diethylene glycol di (meth) acrylate, polypropylene glycol di(meth)acrylates such as a dipropylene glycol di(meth)acrylate, a trimethylolpropane tri(meth)acrylate, a pentaerythritol tri(meth)acrylate, a pentaerythritol tetra(meth)acrylate, a glycerol tri(meth)acrylate, polyvalent (meth) acrylates obtained by addition reaction of a compound having an ethylenic unsaturated bond such as an unsaturated carboxylic acid and an unsaturated alcohol and an active hydrogen with an ethylene glycol diglycidylether, polyvalent (meth) acrylates obtained by addition reaction of a compound having an active hydrogen such as a carboxylic acid and an amine with an unsaturated epoxy compound such as a glycidyl (meth)acrylate, polyvalent (meth)acrylamides such as a methylenebis (meth)acrylamide, and polyvalent vinyl compounds such as divinylbenzene.

The photopolymerization initiator is not particularly limited as long as the photopolymerization initiator can initiate photopolymerization of a photopolymerizable monomer. Examples of the photopolymerization initiator include alkylphenones, acetophenones, benzoin ethers, benzophenones, thioxanthones, anthraquinones, benzils, and biacetyls. Specific examples of the photopolymerization initiator include a benzyl dimethyl ketal, a 2-hydroxy-2-methyl-1-phenyl-propane-1-one, a methyl-O-benzoyl benzoate, and a 1-hydroxycyclohexyl phenyl ketone.

It is preferable that the mixing ratio of the water-dispersible latex and the millable rubber in the photosensitive resin composition should be in the range of 20 to 90% at a mass ratio of the water-dispersible latex to the total mass of the water-dispersible latex and the millable rubber. The mixing ratio is more preferably in the range of 30 to 80%, and still more preferably in the range of 50 to 70%. When the mass ratio is 20% or more, it is possible to perform water development at high speed. This is presumed because the permeability of the aqueous developer liquid into the photosensitive resin composition becomes high. On the other hand, when the mass ratio is 90% or less, the photosensitive resin composition has excellent image reproducibility.

The content of the photopolymerizable monomer in the photosensitive resin composition is preferably in the range of 10 to 80 mass%, and more preferably in the range of 20 to 50 mass%. When the content of the photopolymerizable monomer is 10 mass% or more, there is no lack of crosslink density, and excellent image reproducibility and ink resistance can be obtained. On the other hand, when the content of the photopolymerizable monomer is 80 mass% or less, the relief is not brittle, and it is possible to ensure flexibility that is a feature of a flexographic printing plate.

The content of the photopolymerization initiator in the photosensitive resin composition is preferably in the range of 0.3 to 10 mass%, and more preferably in the range of 0.5 to 5 mass%. When the content of the photopolymerization initiator is 0.3 mass% or more, a photopolymerization reaction of the photopolymerizable monomer occurs sufficiently to form a favorable image. On the other hand, when the content of the photopolymerizable monomer is 5 mass% or less, the sensitivity is not too high, which can facilitate adjustment of the exposure time.

The photosensitive resin composition may contain a surface acting agent for the purpose of improving the water developability. Examples of the surface acting agent include a cationic surface acting agent, an anionic surface acting agent, and a non-ionic surface acting agent. Among the surface acting agents, the anionic surface acting agent is especially preferred.

Specific examples of the anionic surface acting agent include aliphatic carboxylates such as a sodium laurate and a sodium oleate, higher alcohol sulfuric ester salts such as an ester sodium lauryl sulfate, an ester sodium cetyl sulfate, and an ester sodium oleyl sulfate, polyoxyethylene alkyl ether sulfuric ester salts such as an ester sodium polyoxyethylene lauryl ether sulfate, polyoxyethylene alkyl allyl ether sulfuric ester salts such as an ester sodiumpolyoxyethylene octylphenyl ether sulfate and an ester sodium polyoxyethylene nonylphenyl ether sulfate, alkyl sulfonic acid salts such as an alkyl diphenyl ether disulfonic acid salt, a sodium dodecyl sulfonate, and a sodium dialkyl sulfosuccinate, alkyl aryl sulfonic acid salts such as an alkyl disulfonic acid salt, a sodium dodecylbenzene sulfonate, a sodium dibutyl naphthalene sulfonate, and a sodium triisopropyl naphthalene sulfonate, higher alcohol phosphoric acid ester salts such as a disodium lauryl phosphoric acid monoester and a sodium lauryl phosphoric acid diester, and polyoxyethylene alkyl ether phosphoric acid ester salts such as a disodium polyoxyethylene lauryl ether phosphoric acid monoester and a sodium polyoxyethylene lauryl ether phosphoric acid diester. A single kind of the anionic surface acting agent may be used alone, or two or more kinds of the anionic surface acting agents may be used in combination. It is to be noted that while the specific examples include sodium salts, the anionic surface acting agent is not especially limited to the sodium salts, and even calcium salts, ammonium salts, and the like can obtain the same effects.

Among the anionic surface acting agents, the sulfonic acid-based surface acting agents such as alkyl sulfonic acid salts and alkyl aryl sulfonic acid salts are preferred from the viewpoint that the photosensitive resin composition can have further excellent water developability.

The content of the surface acting agent in the photosensitive resin composition is preferably in the range of 0.1 to 20% at a ratio of the mass of the surface acting agent to the total mass of the water-dispersible latex, the millable rubber, and the surface acting agent. The content is more preferably in the range of 0.1 to 15%, and still more preferably in the range of 0.1 to 10%. Making the mass ratio 0.1% or more can allow water development to be performed in a short time. This is presumed because the permeability of the aqueous developer liquid into the photosensitive resin composition becomes high. In addition, making the mass ratio 20% or less can allow the photosensitive resin composition to have excellent drying performance.

The photosensitive resin composition can contain a plasticizing agent for the purpose of imparting flexibility or the like to the photosensitive resin composition. In addition, containing a plasticizing agent can reduce the hardness of the photosensitive resin composition, and thereby the content of the photopolymerizable monomer can be increased. Thus, the ink resistance can be improved.

Examples of the plasticizing agent include liquid rubber, oils, polyesters, and phosphoric acid-based compounds. In particular, plasticizing agents having good compatibility with water-dispersible latexes or millable rubber are preferred. Examples of the liquid rubber include liquid polybutadiene and liquid polyisoprene, or liquid polybutadiene and liquid polyisoprene that are modified with a maleic acid or an epoxy group. Examples of the oils include paraffin, naphthene, and aroma. Examples of the polyesters include adipic acid-based polyesters. Examples of the phosphoric acid compound include ester phosphate.

The content of the plasticizing agent in the photosensitive resin composition is preferably in the range of 0.1 to 30 mass%, and more preferably in the range of 5 to 20 mass%. When the content of the plasticizing agent is 0.1 mass% or more, flexibility can be imparted to the photosensitive resin composition, which can prevent swelling of the photosensitive resin composition caused by a solvent ink. In other words, resistance properties to a solvent ink (resistance properties to solvent ink swelling) improve. On the other hand, when the content of the plasticizing agent is 30 mass% or less, the strength of the photosensitive resin composition can be ensured.

A thermal polymerization inhibitor (stabilizer) can be added to the photosensitive resin composition from the viewpoint of enhancing the thermal stability during kneading and enhancing the storage stability. Examples of the thermal polymerization inhibitor include phenols, hydroquinones, and catechols. The content of the thermal polymerization inhibitor in the photosensitive resin composition is generally in the range of 0.001 to 5 mass%.

Further, other components such as an ultraviolet absorbing agent, a dye, a pigment, an antifoam agent, and a perfume can be added to the photosensitive resin composition as appropriate for the purpose of improving a variety of properties to the extent that these components do not inhibit the effect of the present invention.

The photosensitive resin composition according to the present invention can be prepared, for example, by dehydrating the components while kneading. Alternatively, the photosensitive resin composition according to the present invention can be prepared by dehydrating the water-dispersible latex in advance to knead a polymer obtained from the water-dispersible latex with other components. Examples of a kneading machine used for the kneading include a twin screw extruder, a single screw extruder, a kneader, and a Banbury mixer.

The aqueous developer liquid may be a liquid made of water alone, or may be an aqueous solution made mainly of water to which a compound soluble in water is added. Examples of the compounds soluble in water include a surface acting agent, acid, alkali, and salt. Examples of the surface acting agent include the above-described surface acting agents.

In addition, the aqueous developer liquid may contain an organic solvent soluble in water. Examples of the organic solvent include methanol, ethanol, isopropyl alcohol, cellosolve, glycerin, polyethylene glycol, dimethylformamide, dimethylacetamide, and acetone.

Examples of the acid include inorganic acids and organic acids such as a sulfuric acid, a nitric acid, a phosphoric acid, a formic acid, an acetic acid, an oxalic acid, a succinic acid, a citric acid, a maleic acid, and a p-toluenesulfonic acid. Examples of the alkali include lithium hydroxide, sodium hydroxide, potassium hydroxide, and calcium hydroxide.

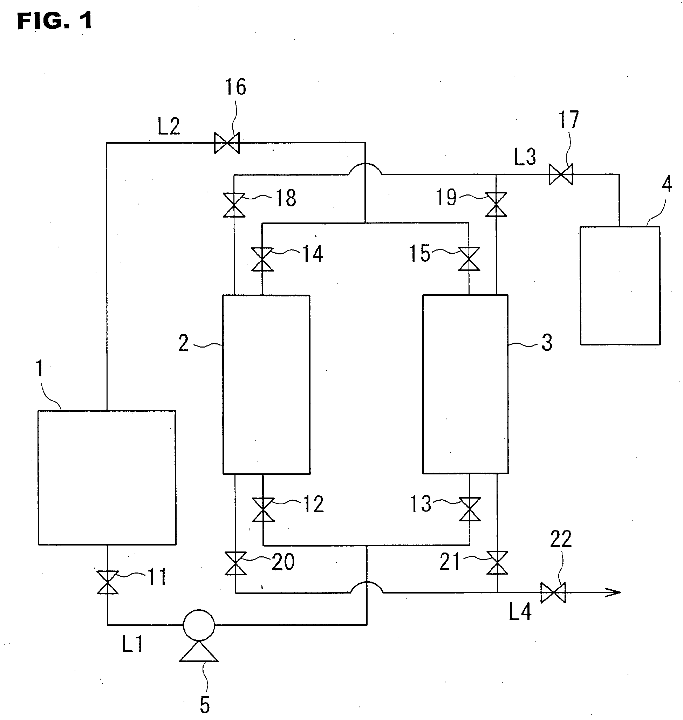

Development of a printing plate member including a photosensitive resin layer on which a latent image is formed is performed with the use of the above-described aqueous developer liquid. Examples of a treatment system for treating a developer waste liquid containing a polymer components that are generated in this developing step include a treatment system having the configuration shown in FIG. 1, for example.

The treatment system includes a first pipe L1 that is connected to an outflow outlet for discharging a developer waste liquid of a developing machine 1, a first packed bed 2 and a second packed bed 3 that are connected to the first pipe L1, a second pipe L2 that is connected to first outflow outlets of the first packed bed 2 and the second packed bed 3, a washing unit 4, a third pipe L3 disposed between the washing unit 4 and the first packed bed 2 and between the washing unit 4 and the second packed bed 3, and a fourth pipe L4 disposed between second outflow outlets of the first packed bed 2 and the second packed bed 3.

The developer waste liquid is discharged from the outflow outlet of the developing machine 1, and the first pipe L1 connected to the outflow outlet functions as a waste liquid recovery unit arranged to recover the developer waste liquid. Note that it is also possible to provide a waste liquid recovery tank for storing the developer waste liquid in a pathway of the first pipe L1 to make the recovery tank function as a waste liquid recovery unit. The first packed bed 2 and the second packed bed 3 are filled with activated carbon. The developer waste liquid passes through either one of the first packed bed 2 and the second packed bed 3 from the first pipe L1. The passage liquid that has passed through either one of the packed beds is replaced to a supply unit supplying an aqueous developer liquid in the developing machine 1 through the second pipe L2 from the first outflow outlet, and the second pipe L2 functions as a passage liquid replacing unit. Note that it is also possible to provide a passage liquid recovery tank for storing the passage liquid in a pathway of the second pipe L2 to make the passage liquid recovery tank function as a passage liquid replacing unit.

The first pipe L1 is disposed between the developing machine 1 and the first packed bed 2, and between the developing machine 1 and the second packed bed 3. A liquid feeding pump 5 is disposed at some midpoint in the first pipe L1, and is capable of sending the developer waste liquid from the developing machine 1 to the first packed bed 2 or the second packed bed 3. The first pipe L1 is bifurcated in midstream while one of the branches is connected to the first packed bed 2 and the other is connected to the second packed bed 3. A valve 11 is provided between the bifurcation point and the developing machine 1, and valves 12 and 13 are provided between the bifurcation point and the first packed bed 2, and between the bifurcation point and the second packed bed 3, respectively. In the first pipe L1, a connected state/non-connected state with the first packed bed 2 is switched through opening and closing operations of the valve 12 while a connected state/non-connected state with the second packed bed 3 is switched through opening and closing operations of the valve 13.

The second pipe L2 is disposed between the developing machine 1 and the first packed bed 2, and between the developing machine 1 and the second packed bed3. The second pipe L2 is bifurcated in midstream while one of the branches is connected to the first packed bed 2 and the other is connected to the second packed bed 3. A valve 16 is provided between the bifurcation point and the developing machine 1, and valves 14 and 15 are provided between the bifurcation point and the first packed bed 2, and between the bifurcation point and the second packed bed 3, respectively. In the second pipe L2, a connected state/non-connected state with the first packed bed 2 is switched through opening and closing operations of the valve 14 while a connected state/non-connected state with the second packed bed 3 is switched through opening and closing operations of the valve 15.

Thus, the developer waste liquid is sent to the first packed bed 2 or the second packed bed 3 through the first pipe L1 from the developing machine 1. At this time, by opening the valves 11 and 12 and closing the valve 13, the developer waste liquid is made to pass through the first packed bed 2. By opening the valves 16 and 14 and closing the valve 15 in synchronization with the opening and closing operations of the valves 11, 12 and 13, the passage liquid in the first packed bed 2 is made to pass through the second pipe L2 to be replaced to the supply unit supplying the aqueous developer liquid in the developing machine 1, and reused as the aqueous developer liquid.

In addition, at this time, by opening the valves 11 and 13 and closing the valve 12, the developer waste liquid is made to pass through the second packed bed 3. By opening the valves 16 and 15 and closing the valve 14 in synchronization with the opening and closing operations of the valves 11, 12 and 13, the passage liquid in the second packed bed 3 is made to pass through the second pipe L2 to be replaced to the supply unit supplying the aqueous developer liquid in the developing machine 1, and reused as the aqueous developer liquid.

The washing unit 4 is connected to the first packed bed 2 and the second packed bed 3 via the third pipe L3, and includes devices such as a boiler and a heater for sending water vapor to these packed beds. The third pipe L3 is disposed between the washing unit 4 and the first packed bed 2, and between the washing unit 4 and the second packed bed 3. The third pipe L3 is bifurcated in midstream while one of the branches is connected to the first packed bed 2 and the other is connected to the second packed bed 3. A valve 17 is provided between the bifurcation point and the washing unit 4, and valves 18 and 19 are provided between the bifurcation point and the first packed bed 2, and between the bifurcation point and the second packed bed 3, respectively. In the third pipe L3, a connected state/non-connected state with the first packed bed 2 is switched through opening and closing operations of the valve 18 while a connected state/non-connected state with the second packed bed 3 is switched through opening and closing operations of the valve 19.

The fourth pipe L4 is connected to the second outflow outlets of the first packed bed 2 and the second packed bed 3. The fourth pipe L4 is bifurcated in midstream while one of the branches is connected to the first packed bed 2 and the other is connected to the second packed bed 3. A valve 22 is provided between the bifurcation point and a discharge outlet, and valves 20 and 21 are provided between the bifurcation point and the first packed bed 2, and between the bifurcation point and the second packed bed 3, respectively. In the fourth pipe L4, a connected state/non-connected state with the first packed bed 2 is switched through opening and closing operations of the valve 20 while a connected state/non-connected state with the second packed bed 3 is switched through opening and closing operations of the valve 21.

Thus, the water vapor from the washing unit 4 is sent to the first packed bed 2 or the second packed bed 3 through the third pipe L3. At this time, by opening the valves 17 and 18 and closing the valve 19, the water vapor is made to pass through the first packed bed 2. By opening the valves 20 and 22 and closing the valve 21 in synchronization with the opening and closing operations of the valves 17, 18 and 19, the water vapor that has passed through the first packed bed 2 passes through the fourth pipe L4 to be discharged from the discharge outlet. In this manner, a washing treatment of the first packed bed 2 is performed.

In addition, at this time, by opening the valves 17 and 19 and closing the valve 18, the water vapor is made to pass through the second packed bed 3. By opening the valves 21 and 22 and closing the valve 20 in synchronization with the opening and closing operations of the valves 17, 18 and 19, the water vapor that has passed through the second packed bed 3 passes through the fourth pipe L4 to be discharged from the discharge outlet. In this manner, a washing treatment of the second packed bed 3 is performed.

The first packed bed 2 and the second packed bed 3 are capable of making a switch alternately between a waste liquid treatment to make the developer waste liquid pass through each of the packed beds and a washing treatment to wash the activated carbon in the packed beds through which the developer waste liquid has been made to pass through the opening and closing operations of the valves 11 to 22.

For example, by opening the valves 11, 12, 14, and 16 and closing the valves 13 and 15, the waste liquid treatment in the first packed bed 2 is performed, and the passage liquid is replaced to the supply unit supplying the aqueous developer liquid in the developing machine 1 to be reused as the aqueous developer liquid. During the time when the waste liquid treatment is performed, by opening the valves 17, 19, 21, and 22 and closing the valves 18 and 20, the water vapor is made to pass through the second packed bed 3 and the washing treatment to wash the activated carbon in the second packed bed 3 is performed.

After the treatment, the valves 19 and 21 are closed to bring about a non-connected state between the washing unit 4 (the third pipe L3) and the second packed bed 3 and between the second packed bed 3 and the fourth pipe L4 (the discharge outlet thereof) and the valves 12 and 14 are closed to bring about a non-connected state between the developing machine 1 (the first pipe L1) and the first packed bed 2 and between the first packed bed 2 and the second pipe L2, while the valves 13 and 15 are opened to bring about a connected state between the developing machine 1 (the first pipe L1) and the second packed bed 3 and between the second packed bed 3 and the second pipe L2 and the valves 18 and 20 are opened to bring about a connected state between the washing unit 4 (the third pipe L3) and the first packed bed 2 and between the first packed bed 2 and the fourth pipe L4 (the discharge outlet thereof), and thus the waste liquid treatment is switched from the first packed bed 2 to the second packed bed 3. The first packed bed 2 is switched to the washing treatment to be prepared for a waste liquid treatment to be performed next time.

The first packed bed 2 and the second packed bed 3 are capable of making a switch alternately between the washing treatment and the waste liquid treatment by the opening and closing operations of the valves. Thus, the activated carbon in the packed beds can be recycled, and the packed beds can be used again in the waste liquid treatment without changing the activated carbon.

In addition, by performing the waste liquid treatment with the use of the two packed beds by switching one packed bed to the other through the opening and closing operations of the valves as described above, the waste liquid treatment can be performed in succession. It is to be noted that while described in the above-described embodiment is an example of using two packed beds, the waste liquid treatment can be performed in succession also with the use of three or more packed beds by switching one packed bed to another through the same operation.

The opening and closing operations of the valve may be performed manually, or may be performed by automatic control by a control unit that is not illustrated.

According to the treatment method and the treatment system for a developer liquid described above, because the developer waste liquid is made to pass through the packed beds filled with the activated carbon, it is possible to remove not only a coagulum in the developer waste liquid but also remove the polymer components and additives dissolved in the developer waste liquid from the developer waste liquid by adsorption. In addition, thus, the passage liquid can be replaced to the supply unit supplying the aqueous developer liquid in the developing machine and reused as the aqueous developer liquid, which allows the treatment system in which the developer waste liquid is not discarded.

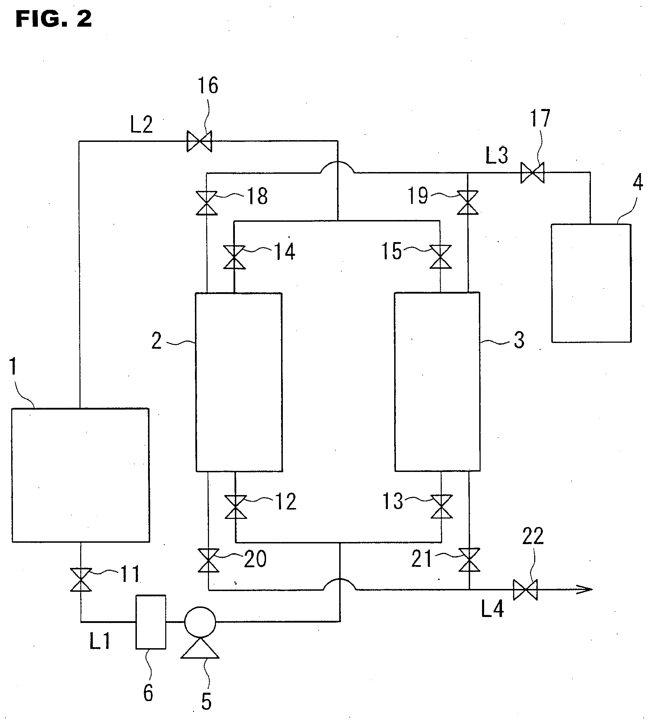

When the polymer components in the photosensitive layer contain water-insoluble components, the water-insoluble components dispersed in the developer waste liquid can be coagulated with the use of a high-polymer coagulant. The coagulated polymer components can be removed as a solid content with the use of a filter such as a nonwoven fabric. For example, as shown in FIG. 2, installing a filter 6 upstream of the packed beds to remove the solid content in advance from the developer waste liquid can reduce the components to be removed in the packed beds. Thus, the amount of the components to be absorbed by the activated carbon in the packed beds can be reduced, so that the recycling of the activated carbon can be reduced in frequency.

### [Examples]

Hereinafter, detailed descriptions of the present invention will be provided using the Examples.

### (Examples)

### <Preparation of photosensitive resin composition>

54.6 parts by mass of a water-dispersible latex (a polymer as a solid content is 30 parts by mass), 10 parts by mass of acrylic-modified liquid BR, and 10 parts by mass of an acrylic monomer were mixed, the water in the mixture was evaporated for 2 hours in a dryer heated to 120°C, and thus a mixture of the polymer obtained from the water-dispersible latex and the photopolymerizable monomer was obtained. Thus-obtained mixture, 25 parts by mass of BR, 8 parts by mass of a surface acting agent (a polymer as a solid content is 4 parts by mass), and 10 parts by mass of a plasticizing agent were kneaded for 45 minutes in a kneader. Then, 0.2 parts by mass of a thermal polymerization inhibitor and one part by mass of a photopolymerization initiator were charged in the kneader to be kneaded for five minutes, and thus a photosensitive resin composition was prepared.

The components used in the present embodiment are specifically described below.
- Polymer obtained from a water-dispersible latex (manufactured by ZEON CORPORATION, NIPOL LX111NF)
- BR: [manufactured by ZEON CORPORATION, NIPOL BR1220]
- Acrylic-modified liquid BR: [manufactured by OSAKA ORGANIC CHEMICAL INDUSTRY LTD., BAC-45]
- Acrylic monomer: [manufactured by NOF CORPORATION, 1,9-nonanediol dimethacrylate]
- Photopolymerization initiator: [manufactured by CIBA JAPAN KK, IRGACURE 651]
- Surface acting agent: [manufactured by NOF CORPORATION, NEW LEX R]
- Plasticizing agent: [manufactured byESSO SEKIYU K. K., CRYSTOL 70]
- Thermal polymerization inhibitor: [manufactured by SEIKO CHEMICAL CO., LTD., MEHQ (hydroquinone monomethyl ether)]

### <Preparation of printing plate member>

Thus-obtained photosensitive resin composition was sandwiched between a board obtained by coating an adhesive agent in advance on one side of a PET film 125 µm thick and a protection film obtained by coating an anti-adhesive agent in advance on one side of a PET film 100 µm thick, and pressed with the use of a pressing machine heated to 120 °C so that the thickness of the photosensitive resin composition becomes 1 mm. Thus, a printing plate member was prepared in which the adhesive agent layer, the photosensitive layer including the photosensitive resin composition, the anti-adhesive agent layer, and the protection film were laminated in this order on the board.

### (Developing step)

After a base was formed by irradiating the printing plate member from the board side with ultraviolet rays with the use of an exposure device including 15 chemical lamps of 80 W, the protection film was removed therefrom, and an image reproducibility evaluation negative film (having halftone dots "150 Lpi/2%" and "independent points ϕ 120 µm") was vacuum-contacted on the photosensitive layer, and the printing plate member was exposed (main exposure) for six minutes from the above of the negative film from a distance of 15 cm with the use of the above-described exposure device. Then, the negative film was removed from the printing plate member, and the printing plate member was washed for ten minutes with the use of the aqueous developer liquid containing a surface acting agent (one mass%), and dried sufficiently with hot air at 50°C. As described above, the printing plate was prepared.

### (Composition of developer waste liquid)

In the above-described developing step, five A3-sized printing plates were produced. TOCs (Total Organic Carbon) of the Generated developer waste liquids were measured (a measurement method: a combustion oxidation - infrared analysis method, a measuring device: "TOC-V" (manufactured by SHIMADZU CORPORATION)), and measured 2464 mg/L.

### (Treatment of developer waste liquid)

The above-described developer waste liquid was made to pass through the packed beds filled with the activated carbon, and the TOCs of the passage liquids were measured in the same manner as the developer waste liquid, and the measured TOCs were decreased to 156 mg/L.

### (Comparative Example 1)

The above-described development waste liquid was made to pass through a 200-mesh/100-mesh filter made of a nonwoven fabric, and the TOC of the passage liquid thereof was measured in the same manner as the developer waste liquid. As the result, the measured TOC was 1130 mg/L.

### (Comparative Example 2)

Aluminum sulfate (manufactured by ASAHI CHEMICAL, aluminum sulfate) was added to the above-described development waste liquid as an aggregating agent (addition concentration of one mass% with respect to the total amount of the developer waste liquid), and the polymer components were coagulated. Then, the development waste liquid was made to pass through a 200-mesh/100-mesh filter made of a nonwoven fabric, and the TOC of the passage liquid thereof was measured in the same manner as the developer waste liquid. As the result, the measured TOC was 545 mg/L.

The foregoing description of the preferred embodiment and the examples of the present invention has been presented for purposes of illustration and description; however, it is not intended to be exhaustive or to limit the present invention to the precise form disclosed, and modifications and variations are possible as long as they do not deviate from the principles of the present invention.

For example, while described in the above-described embodiment is an example of using the two packed beds 2 and 3, an embodiment where either one of the packed beds is used is possible.

## Claims

1. A method for treating a printing plate developer liquid, the method comprising the steps of:
performing a waste liquid treatment by making a developer waste liquid pass through a packed bed filled with activated carbon, the developer waste liquid containing a polymer component that is generated in a developing step to perform development of a printing plate member comprising a photosensitive resin layer on which a latent image is formed with the use of an aqueous developer liquid mainly comprising water, the polymer content comprising a water-insoluble polymer selected from butadiene rubber, chloroprene rubber, acrylonitrile butadiene rubber, acrylic rubber, epichlorohydrin rubber, urethane rubber, isoprene rubber, styrene-isoprene rubber, styrene-butadiene rubber, ethylene-propylene copolymer, and chlorinated polyethylene; and
replacing a passage liquid that is made to pass through the packed bed in a supply unit supplying the aqueous developer liquid in a developing machine (1), and reusing the passage liquid as an aqueous developer liquid,
wherein a switch is made alternately between a washing treatment to wash the activated carbon in the packed bed by making water vapor pass through the packed bed through which the developer waste liquid is made to pass and a waste liquid treatment to make the developer waste liquid pass through the packed bed filled with the activated carbon.

2. The method for treating a printing plate developer liquid according to claim 1,
wherein the packed bed comprises a plurality of packed beds (2,3), and while the waste liquid treatment is performed on one packed bed to another, the washing treatment is performed on one of the packed beds in which the waste liquid treatment is stopped when the waste liquid treatment is performed on another packed bed.

3. The method for treating a printing plate developer liquid according to claim 1 or 2,
wherein a solid content is removed from the developer waste liquid by a filter (6) installed upstream of the packed bed in advance of the waste liquid treatment.

4. The method for treating a printing plate developer liquid according to claim 3,
wherein the water-insoluble polymer dispersed in the developer waste liquid is coagulated to form the solid content with the use of a high-polymer coagulant.

## Patentansprüche

1. Verfahren zur Behandlung einer Druckplatten-Entwicklerflüssigkeit, das Verfahren umfassend die Schritte:
Durchführen einer Abfallflüssigkeitsbehandlung, in dem eine Entwicklerabfall-flüssigkeit durch ein gepacktes Bett gefüllt mit Aktivkohle geleitet wird, wobei die Entwicklerabfallflüssigkeit einen Polymerbestandteil enthält, der in einem Entwicklungsschritt erzeugt wird, um das Entwickeln eines Druckplattenbestandteils, umfassend eine lichtempfindliche Harzschicht, auf der ein latentes Bild gebildet wird, unter Verwendung einer wässrigen Entwicklerflüssigkeit, hauptsächlich umfassend Wasser, durchzuführen, der Polymergehalt ein wasserunlösliches Polymer, ausgewählt aus Butadien-Gummi, Chloropren-Gummi, Acrylonitril-Butadien-Gummi, Acryl-Gummi, Epichlorohydrin-Gummi, Urethan-Gummi, Isopren-Gummi, Styrol-Isopren-Gummi, Styrol-Butadien-Gummi, Ethylen-Propylen-Copolymer und chloriertem Polyethylen, umfasst; und
Ersetzen einer Durchgangsflüssigkeit, die durch das gepacktes Bett geleitet wird, in einer Versorgungseinheit, die die wässrige Entwicklerflüssigkeit in einer Entwicklermaschine (1) bereitstellt, und Wiederverwenden der Durchgangsflüssigkeit als eine wässrige Entwicklerflüssigkeit,
wobei zwischen einer Waschbehandlung, um die Aktivkohle in dem gepackten Bett zu waschen, indem Wasserdampf durch das gepackte Bett, durch das die Entwicklerabfallflüssigkeit geleitet wird, geleitet wird und einer Abfallflüssigkeitsbehandlung, um die Entwicklerabfallflüssigkeit durch das gepackte Bett gefüllt mit Aktivkohle zu leiten, alternierend gewechselt wird.

2. Verfahren zur Behandlung einer Druckplatten-Entwicklerflüssigkeit nach Anspruch 1,
wobei das gepackte Bett eine Vielzahl von gepackten Betten (2,3) umfasst, und während die Abfallflüssigkeitsbehandlung an einem der gepackten Betten zu einem anderen durchgeführt wird, die Waschbehandlung an einem der gepackten Betten, in denen die Abfallflüssigkeitsbehandlung angehalten ist, wenn die Abfalllflüssigkeitsbehandlung an einem anderen gepackten Bett durchgeführt wird, durchgeführt wird.

3. Verfahren zur Behandlung einer Druckplatten-Entwicklerflüssigkeit nach Anspruch 1 oder 2,
wobei ein Feststoffgehalt von der Entwicklerabfallflüssigkeit mit einem Filter (6), der stromaufwärts des gepackten Betts installiert ist, vor der Abfallflüssigkeits-behandlung entfernt wird.

4. Verfahren zur Behandlung einer Druckplatten-Entwicklerflüssigkeit nach Anspruch 3,
wobei das wasserunlösliche, in der Entwicklerabfallflüssigkeit dispergierte Polymer unter Verwendung eines hochpolymeren Koagulationsmittel koaguliert wird, um den Feststoffgehalt zu bilden.

## Revendications

1. Procédé de traitement d'un liquide révélateur de plaque d'impression, le procédé comprenant les étapes consistant à :
réaliser un traitement du liquide résiduaire en faisant passer un liquide révélateur résiduaire sur un lit garni chargé de charbon actif, le liquide révélateur résiduaire contenant un composant polymère qui est généré dans une étape de développement pour effectuer le développement d'un élément de plaque d'impression comprenant une couche de résine photosensible sur laquelle une image latente est formée en utilisant un liquide révélateur aqueux comprenant essentiellement de l'eau, le contenu polymère comprenant un polymère insoluble dans l'eau choisi parmi un caoutchouc butadiène, un caoutchouc chloroprène, un caoutchouc acrylonitrilebutadiène, un caoutchouc acrylique, un caoutchouc épichlorhydrine, un caoutchouc uréthanne, un caoutchouc isoprène, un caoutchouc styrène-isoprène, un caoutchouc styrène-butadiène, un copolymère éthylène-propylène et un polyéthylène chloré, et
introduire le liquide de passage obtenu par passage sur le lit garni dans une unité d'apport alimentant une machine de développement (1) en liquide révélateur aqueux, et réutiliser le liquide de passage comme liquide révélateur aqueux,
où on passe alternativement d'un traitement de lavage pour laver le charbon actif dans le lit garni en fraisant passer de !a vapeur d'eau sur le lit garni sur lequel le liquide révélateur résiduaire a été passé, et un traitement du liquide résiduaire pour faire passer le liquide révélateur résiduaire sur le lit garni chargé de charbon actif.

2. Procédé de traitement d'un liquide révélateur de plaque d'impression selon la revendication 1, où le lit garni comprend une série de lits garni (2, 3) et alors que le traitement du liquide résiduaire est réalisé sur un lit garni, le traitement de lavage est réalisé sur un des lits garnis sur lequel le traitement du liquide résiduaire est arrêté lorsque celui-ci est réalisé sur un autre lit garni.

3. Procédé de traitement d'un liquide révélateur de plaque d'impression selon la revendication 1 ou 2, où une certaine quantité de matières solides est éliminée du liquide révélateur résiduaire par un filtre (6) installé en amont du lit garni, préalablement au traitement du liquide résiduaire.

4. Procédé de traitement d'un liquide révélateur de plaque d'impression selon la revendication 3, où le polymère insoluble dans l'eau dispersé dans le liquide révélateur résiduaire est coagulé à l'aide d'un coagulant pour polymère, pour former les matières solides.
